# EUROPEAN PATENT APPLICATION

(11) **EP 4 621 784 A2**
(43) Date of publication of application: **24.09.2025**
(21) Application number: 25161218.0
(22) Date of filing: 03.03.2025
(51) Int. Cl.: G11C 11/412, G11C 11/419

(54) **STATIC RANDOM ACCESS MEMORY USING MICRO-ELECTROMECHANICAL SYSTEMS**

(30) Priority: 22.03.2024 IN 202411022045; 15.05.2024 US 202418665338
(71) Applicant: Honeywell International Inc., Charlotte, NC 28202 (US)
(72) Inventor: PRAKASH, Sruthy, Charlotte, NC 28202 (US); DEEPTHI, Bathula, Charlotte, NC 28202 (US); T P, Pranati, Charlotte, NC 28202 (US)
(74) Representative: Haseltine Lake Kempner LLP

(57) **Abstract**

An SRAM cell includes electro-mechanical transistors each having
a source terminal, a gate terminal, a drain terminal, and a cantilever beam connected to the source terminal that, responsive to an electrostatic force generated by a potential difference between the source terminal and the drain terminal, deflects to connect the drain terminal to the source terminal. The SRAM cell also includes a bistable latch having a first storage node and a second storage node complementary to the first storage node. First and second electro-mechanical transistors are connected to the Bistable latch. A word line is connected to the gate terminals of the first and second electro-mechanical transistors. The first and second electro-mechanical transistors are operable to, responsive to the word line being asserted, enable reading from and writing to the first storage node and the second storage node via a bit line and a complementary bit line.

## Description

This application claims the benefit of Indian Provisional Patent Application No. 202411022045, filed March 22, 2024 and entitled "STATIC RANDOM ACCESS MEMORY USING MICRO-ELECTROMECHANICAL SYSTEMS," the entire contents of which is incorporated herein by reference.

### TECHNICAL FIELD

The disclosure relates to Static Random Access Memory.

### BACKGROUND

Static Random Access Memory (SRAM) is a type of semiconductor memory widely used in portable devices, system-on-chip (SOC) circuits, and high-performance very-large-scale integration (VLSI) circuits. SRAM is considered to be non-volatile memory because, unlike certain other types of memory, such as Dynamic RAM (DRAM), SRAM does not need to be periodically refreshed. Instead, SRAM is able to maintain data as long as power is supplied.

### SUMMARY

In general, this disclosure describes an SRAM cell that uses micro-electromechanical systems (MEMS) structures in place of semiconductor transistors, such as complementary metal-oxide-semiconductor (CMOS) transistors. In the example of a 6T SRAM cell, each of the six transistors of the SRAM cell can be replaced with a MEMS structure.

The MEMS structures may be an electro-mechanical transistor that includes a source terminal, a gate terminal, and a drain terminal, and a cantilever beam connected to the source terminal that is cantilevered above the gate terminal and the drain terminal. When there is a potential difference between the source terminal and the drain terminal, the potential difference generates an electrostatic force that pulls down the cantilever beam to contact the drain terminal. By contacting both the source terminal and the drain terminal, the cantilevered beam creates an electrical short between the source terminal and the drain terminal, allowing current to flow between the source terminal and the drain terminal.

In some aspects, the techniques described herein relate to a Static Random Access Memory (SRAM) cell including: a set of electro-mechanical transistors, wherein each electro-mechanical transistor of the set of electro-mechanical transistors includes: a source terminal; a gate terminal; a drain terminal; and a cantilever beam connected to the source terminal, wherein the cantilever beam is operable to deflect to connect the drain terminal to the source terminal responsive to an electrostatic force generated by a potential difference between the source terminal and the drain terminal; and a bistable latch connected to a supply voltage and to a ground, the bistable latch having a first storage node and a second storage node, the second storage node being complementary to the first storage node, wherein the drain terminal of a first electro-mechanical transistor of the set of electro-mechanical transistors is connected to the first storage node, and wherein the drain terminal of a second electro-mechanical transistor of the set of electro-mechanical transistors is connected to the second storage node; wherein the gate terminal of the first electro-mechanical transistor and the gate terminal of the second electro-mechanical transistor are connected to a word line; wherein the source terminal of the first electro-mechanical transistor is connected to a bit line; wherein the source terminal of the second electro-mechanical transistor is connected to a complementary bit line; and wherein the first electro-mechanical transistor and the second electro-mechanical transistor are operable to enable reading from and writing to the first storage node and the second storage node via the bit line and the complementary bit line responsive to the word line being asserted.

In some aspects, the techniques described herein relate to a Static Random Access Memory (SRAM) device including: a plurality of word lines; a plurality of bit lines; a plurality of complementary bit lines; a plurality of driving circuitries operable to drive the plurality of word lines; a plurality of SRAM cells, wherein each SRAM cell of the plurality of SRAM cells includes: a set of electro-mechanical transistors, wherein each electro-mechanical transistor of the set of electro-mechanical transistors includes: a source terminal; a gate terminal; a drain terminal; and a cantilever beam connected to the source terminal, wherein the cantilever beam is operable to deflect to connect the drain terminal to the source terminal responsive to an electrostatic force generated by a potential difference between the source terminal and the drain terminal; and a bistable latch connected to a supply voltage and to a ground, the bistable latch having a first storage node and a second storage node, the second storage node being complementary to the first storage node, wherein the drain terminal of a first electro-mechanical transistor of the set of electro-mechanical transistors is connected to the first storage node, and wherein the drain terminal of a second electro-mechanical transistor of the set of electro-mechanical transistors is connected to the second storage node; wherein the gate terminal of the first electro-mechanical transistor and the gate terminal of the second electro-mechanical transistor are connected to a word line of the plurality of word lines; wherein the source terminal of the first electro-mechanical transistor is connected to a bit line of the plurality of bit lines; wherein the source terminal of the second electro-mechanical transistor is connected to a complementary bit line of the plurality of complementary bit lines; and wherein the first electro-mechanical transistor and the second electro-mechanical transistor are operable to enable reading from and writing to the first storage node and the second storage node via the bit line and the complementary bit line responsive to the word line being asserted by a corresponding driving circuitry of the plurality of driving circuitries.

In some aspects, the techniques described herein relate to a method of operating a memory device including: driving, by a driving circuitry of a memory device, a word line connected to a Static Random Access Memory (SRAM) cell of a plurality of SRAM cells of the memory device to a supply voltage; driving, by a write driving circuitry of the memory device, a bit line connected to a SRAM cell of the plurality of SRAM cells to a ground voltage to write a bit value of 0 to the SRAM cell; and in response to the word line being driven to the supply voltage, generating, by an electro-mechanical transistor of the SRAM cell, the electro-mechanical transistor having a source terminal connected to the bit line, a gate terminal connected to the word line, and a drain terminal connected to a storage node of the SRAM cell, an electrostatic force between the source terminal and the gate terminal that pulls a cantilever beam connected to the source terminal down to connect the drain terminal to the source terminal to write the bit value of 0 to the storage node.

The details of one or more examples of the disclosure are set forth in the accompanying drawings and the description below. Other features, objects, and advantages of the disclosure will be apparent from the description and drawings, and from the claims.

### BRIEF DESCRIPTION OF DRAWINGS

FIG. 1A illustrates an example electro-mechanical transistor that acts as a mechanical relay switch.
FIG. 1B illustrates the unit symbol for the electro-mechanical transistor of FIG. 1A.
FIG. 1C is a schematic diagram of an inverter built using the electro-mechanical transistor of FIG. 1A.
FIG. 2 is a schematic diagram illustrating an example SRAM cell that uses electro-mechanical transistors, in accordance with aspects of this disclosure.
FIG. 3 is a schematic diagram illustrating an example SRAM device having SRAM cells that uses electro-mechanical transistors, in accordance with aspects of this disclosure.
FIG. 4 is a flow chart illustrating example operations of a memory device, in accordance with aspects of this disclosure.
FIG. 5 is a flow chart illustrating example operations of a memory device, in accordance with aspects of this disclosure.

### DETAILED DESCRIPTION

The disclosure describes a Static Random Access Memory (SRAM) cell that uses micro-electromechanical systems (MEMS) structures as transistors. Using MEMS structures in place of semiconductor transistors, such as complementary metal-oxide-semiconductor (CMOS) transistors, may improve the performance and reliability of SRAM.

MEMS structures are miniature mechanical and electro-mechanical components that combine silicon-based microelectronic components with mechanical systems and are typically fabricated using a microfabrication process. MEMS structures can be used for microscale sensing, control, actuation, and other applications.

Memories are used in many different types of electronic design. One type of memory is SRAM. SRAM is non-volatile memory because, unlike certain other types of memory, SRAM does not need to be periodically refreshed. Instead, SRAM is able to maintain data as long as power is supplied.

SRAM cells typically uses CMOS transistors to store bit values and to enable read and write operations. However, there are potential technical disadvantages to using CMOS transistors in SRAM cells. CMOS transistors may be relatively large in size, relatively power hungry, and may have relatively high switching time. Further, CMOS transistors may be vulnerable to single event upsets, which may make CMOS transistors unsuitable for space or high-altitude applications.

In accordance with aspects of this disclosure, cells of an SRAM may use MEMS structures as transistors, such as in place of CMOS transistors. A MEMS structure may be in the form of an electro-mechanical transistor that includes a source terminal, a gate terminal, a drain terminal, and a cantilever beam connected to the source terminal that is cantilevered above the gate terminal and the drain terminal. When there is a potential difference between the source terminal and the gate terminal, the potential difference generates an electrostatic force that pulls down the cantilever beam to contact the drain terminal. By contacting both the source terminal and the drain terminal, the cantilevered beam creates an electrical short between the source terminal and the drain terminal, allowing current to flow between the source terminal and the drain terminal.

Using MEMS structures in place of CMOS transistors in SRAM cells may provide certain technical advantages. A MEMS transistor may be smaller in size compared with a CMOS transistor, which may decrease the size of SRAM cells that uses MEMS transistors. MEMS transistors may also have faster switching times and lower power consumption compared with CMOS transistors. Further, MEMS transistors may, due to low ionization radiation of MEMS transistors, be less vulnerable to single event upsets compared to CMOS transistors, which may enable MEMS transistors to be more suitable for use in flight systems in space or high-altitude applications.

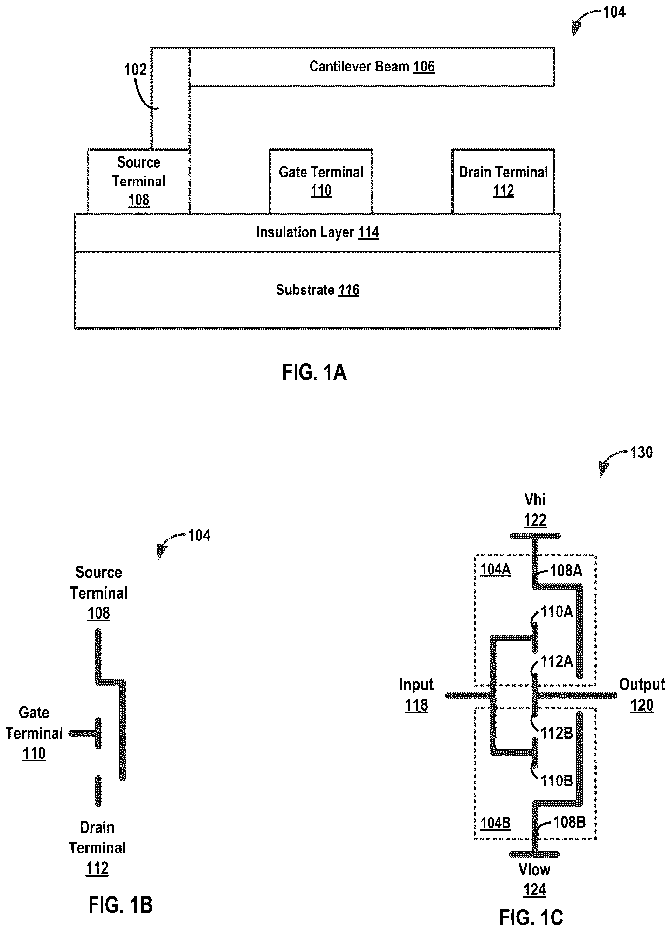

FIG. 1A illustrates an example electro-mechanical transistor that acts as a mechanical relay switch. Such an electro-mechanical transistor can be used in place of semiconductor transistors, such as complementary metal-oxide-semiconductor (CMOS) transistors in Static Random Access Memory (SRAM).

As shown in FIG. 1A, electro-mechanical transistor 104 is a MEMS or nano-electromechanical systems (NEMS) transistor that includes source terminal 108, gate terminal 110, and drain terminal 112, which are electrically isolated by insulation layer 114 on top of substrate 116. In some examples, source terminal 108, gate terminal 110, and drain terminal 112 are made of silicon. In some examples, substrate 116 may be a silicon substrate.

Electro-mechanical transistor 104 also includes cantilever beam 106. Cantilever beam 106 is a structural element that extends horizontally and is supported on only one end by support portion 102 of cantilever beam 106. Cantilever beam 106 may be a mechanical cantilever beam and may be made of silicon, polysilicon, silicon nitride, silicon dioxide, or any other suitable material. Cantilever beam 106 contacts source terminal 108 via support portion 102 of cantilever beam 106 and is cantilevered from source terminal 108 over and above gate terminal 110 and drain terminal 112.

Source terminal 108 and gate terminal 110 are voltage controlled. When there is not a potential difference between source terminal 108 and gate terminal 110, there is no mechanical action in electro-mechanical transistor 104.

When there is a potential difference between source terminal 108 and gate terminal 110, the potential difference causes an electrostatic force to be generated between source terminal 108 and gate terminal 110. The generated electrostatic force may deflect cantilever beam 106, such as pulling cantilever beam 106 downwards towards drain terminal 112, and may therefore cause cantilever beam 106 to contact drain terminal 112. That is, cantilever beam 106, may, responsive to the electrostatic force, deflect (e.g., bend) downwards towards drain terminal 112 to contact drain terminal 112, thereby connecting source terminal 108 to drain terminal 112.

Because cantilever beam 106 is already in contact source terminal 108, cantilever beam 106 may, by contacting drain terminal 112, create an electrical short between source terminal 108 and drain terminal 112. The electrical short may enable current to flow between source terminal 108 and drain terminal 112. When the potential difference between source terminal 108 and gate terminal 110 disappears, the electrostatic force between source terminal 108 and gate terminal 110 may also disappear, which may cause cantilever beam 106 to deflect away from and no longer contact drain terminal 112.

In some examples, because cantilever beam 106 is cantilevered over gate terminal 110 and drain terminal 112, when there is a potential difference between gate terminal 110 and drain terminal 112, the potential difference causes an electrostatic force to be generated between gate terminal 110 and drain terminal 112. The generated electrostatic force may deflect cantilever beam 106, such as pulling cantilever beam 106 downwards towards drain terminal 112, and may therefore cause cantilever beam 106 to contact drain terminal 112. When the potential difference between gate terminal 110 and drain terminal 112 disappears, the electrostatic force between gate terminal 110 and drain terminal 112 may also disappear, which may cause cantilever beam 106 to deflect away from and no longer contact drain terminal 112.

FIG. 1B illustrates the unit symbol for electro-mechanical transistor 104 of FIG. 1A. The operational output of electro-mechanical transistor 104 depending on the potential difference applied between source terminal 108 and gate terminal 110 is expressed in Table 1.

**Table 1**

| **Source** | **Gate** | **Drain** |
|---|---|---|
| 0 | 0 | Z |
| 0 | 1 | 0 |
| 1 | 0 | 1 |
| 1 | 1 | Z |

As can be seen, there is a potential difference between source terminal 108 and gate terminal 110 when source terminal 108 is at a high voltage state while gate terminal 110 is at a low voltage state (demoted as 1 for source terminal 108 and 0 for gate terminal 110) or when source terminal 108 is at a low voltage state while gate terminal 110 is at a high voltage state (demoted as 0 for source terminal 108 and 1 for gate terminal 110). When there is a potential difference between source terminal 108 and gate terminal 110, the electrostatic force generated by the potential difference deflects the cantilever beam 106 and pulls cantilever beam 106 down to contact drain terminal 112 to electrically short source terminal 108 and drain terminal 112. The electrical short between source terminal 108 and drain terminal 112 causes drain terminal 112 to take on the voltage state of source terminal 108.

FIG. 1C is a schematic diagram of an inverter built using electro-mechanical transistor 104 of FIG. 1A. As shown in FIG. 1C, inverter 130 may be made up of electro-mechanical transistor 104A and electro-mechanical transistor 104B, each of which is an example of electro-mechanical transistor 104 of FIG. 1A. Electro-mechanical transistors 104A and 104B may replace a N-type metal-oxide-semiconductor (NMOS) transistor and a P-type metal-oxide-semiconductor (PMOS) transistor that together form a CMOS inverter.

Electro-mechanical transistor includes source terminal 108A, gate terminal 110A, and drain terminal 112A. Electro-mechanical transistor 104B includes source terminal 108B, gate terminal 110B, and drain terminal 112B. Drain terminal 112A of electro-mechanical transistor 104A is connected to drain terminal 112B of electro-mechanical transistor 104B in inverter 130, and both drain terminal 112A and drain terminal 112B are connected to output 120. Source terminal 108A of electro-mechanical transistor 104A is connected to high voltage source (Vhi) 122, and source terminal 108B of electro-mechanical transistor 104B is connected to a low voltage source (Vlow) 124. Gate terminal 110A of electro-mechanical transistor 104A and gate terminal 110B of electro-mechanical transistor 104B are each connected to input 118.

When an input of 0 is applied via input 118 to inverter 130, there is no potential difference between source terminal 108B and gate terminal 110B of electro-mechanical transistor 104B. However, there is a potential difference between source terminal 108A and gate terminal 110A of electro-mechanical transistor 104A, which pulls down the cantilever beam of electro-mechanical transistor 104A to electrically short source terminal 108A and drain terminal 112A. The short between source terminal 108A, which is connected to high voltage 122, and drain terminal 112A of electro-mechanical transistor 104A causes drain terminal 112A to output a 1 at output 120.

When an input of 1 is applied via input 118 to inverter 130, there is no potential difference between source terminal 108A and gate terminal 110A of electro-mechanical transistor 104A. However, there is a potential difference between source terminal 108B and gate terminal 110B of electro-mechanical transistor 104B, which pulls down the cantilever beam of electro-mechanical transistor 104B to electrically short source terminal 108B and drain terminal 112B. The short between source terminal 108B, which is connected to low voltage 124, and drain terminal 112B of electro-mechanical transistor 104B causes drain terminal 112B to output a 0 at output 120.

In accordance with aspects of this disclosure, a Static Random Access Memory (SRAM) cell may include electro-mechanical transistors, such as electro-mechanical transistor 104 illustrated in FIGS. 1A and 1B, and inverters, such as inverter 130 illustrated in FIG. 1C, built from electro-mechanical transistors in place of CMOS structures and inverters in the SRAM. An SRAM cell may use electro-mechanical transistor 104 to store bit values and to enable read and write operations of the SRAM cell in ways that improves the performance and reliability of the SRAM cell.

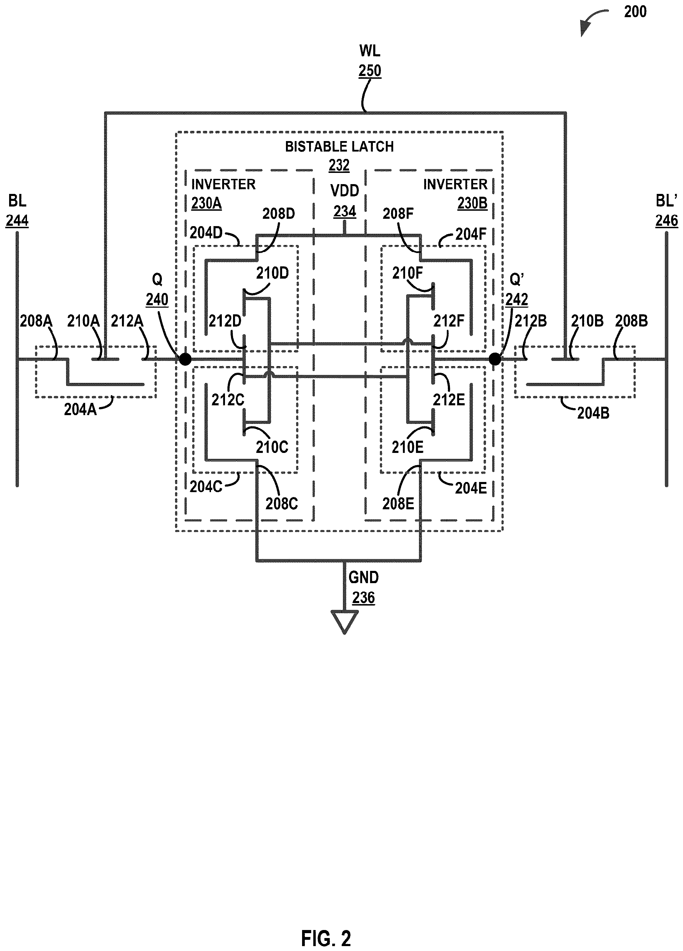

FIG. 2 is a schematic diagram illustrating an example SRAM cell that uses electro-mechanical transistors, in accordance with aspects of this disclosure. While FIG. 2 illustrates a 6T SRAM cell, the techniques of this disclosure may be equally applicable for building any other types of SRAM cells.

As shown in FIG. 2, SRAM cell 200 includes a set of electro-mechanical transistors 204A-204E ("electro-mechanical transistors 204"), each of which is an example of electro-mechanical transistor 104 of FIGS. 1A-1C, in place of transistors, such as complementary metal-oxide-semiconductor (CMOS) transistors, in SRAM cell 200. Such electro-mechanical transistors may be MEMS or NEMS transistors.

Electro-mechanical transistor 204A includes source terminal 208A, gate terminal 210A, and drain terminal 212A. Source terminal 208A is connected to bit line (BL) 244 for SRAM cell 200 and gate terminal 210A is connected to word line (WL) 250 for SRAM cell 200. electro-mechanical transistor 204B includes source terminal 208B, gate terminal 210B, and drain terminal 212B. Source terminal 208B is connected to complementary bit line (BL') 246, also referred to as a bit bar line, for SRAM cell 200, and gate terminal 210B is connected to word line 250 for SRAM cell 200. As can be seen, SRAM cell 200 uses electro-mechanical transistor 204A and electro-mechanical transistor 204B in place of CMOS pass-gate transistors that connect to bit line 244, complementary bit line 246, and word line 250.

Drain terminal 112A of electro-mechanical transistor 204A and drain terminal 112B of electro-mechanical transistor 204B are connected to bistable latch 232 that stores a single bit of information in SRAM cell 200. Bistable latch 232 includes a pair of cross-coupled inverters 230A and 230B, each of which is an example of inverter 130 of FIG. 1C, that are cross-connected to each other, such that the two inverters 230A and 230B are connected in a loop, where the output of one inverter is fed into the other inverter, and vice versa.

Inverter 230A includes electro-mechanical transistor 204C and electro-mechanical transistor 204D. electro-mechanical transistor 204C includes source terminal 208C, gate terminal 210C, and drain terminal 212C. electro-mechanical transistor 204D includes source terminal 208D, gate terminal 210D, and drain terminal 212D. In inverter 230A, gate terminal 210C of electro-mechanical transistor 204C is connected to gate terminal 210D of electro-mechanical transistor 204D, and drain terminal 212C of electro-mechanical transistor 204C is connected to drain terminal 212D of electro-mechanical transistor 204D. Source terminal 208D of electro-mechanical transistor 204D is connected to supply voltage (VDD) 234. Source terminal 208C of electro-mechanical transistor 204C is connected to ground (GND) 236.

Inverter 230B includes electro-mechanical transistor 204E and electro-mechanical transistor 204F. electro-mechanical transistor 204E includes source terminal 208E, gate terminal 210E, and drain terminal 212E. electro-mechanical transistor 204F includes source terminal 208F, gate terminal 210F, and drain terminal 212F. In inverter 230B, gate terminal 210E of electro-mechanical transistor 204E is connected to gate terminal 210F of electro-mechanical transistor 204F, and drain terminal 212E of electro-mechanical transistor 204E is connected to drain terminal 212F of electro-mechanical transistor 204F. Source terminal 208F of electro-mechanical transistor 204F is connected to VDD 234. Source terminal 208E of electro-mechanical transistor 204E is connected to GND 236.

As discussed above, inverters 230A and 230B are cross connected to each other in bistable latch 232. To cross-connect inverters 230A and 230B, gate terminals 210C and 210D in inverter 230A are connected to drain terminals 212E and 212F in inverter 230B, and gate terminals 210E and 210F in inverter 230B are connected to drain terminals 212C and 212D in inverter 230A.

Bistable latch 232 includes storage node (Q) 240 and complementary storage node (Q') 242 each operable to store a bit value. Storage node 240 and complementary storage node 242 are complementary in that when storage node 240 stores a bit value of 0, then complementary storage node 242 stores a bit value of 1, and when storage node 240 stores a bi value of 1, then complementary storage node 242 stores a bit value of 0.

To govern read and writes of bistable latch 232, drain terminal 212A of electro-mechanical transistor 204A is connected to drain terminals 212C and 212D in inverter 130A. Similarly, drain terminal 212B of electro-mechanical transistor 204B is connected to drain terminals 212E and 212F in inverter 230B.

When the voltage of word line 250 is asserted (i.e., switched to a system high voltage such as supply voltage), electro-mechanical transistors 204A and 204B are turned on, thereby enabling SRAM cell 200 may perform read operations from bistable latch 232 and to perform write operations to bistable latch 232. That is, electro-mechanical transistors 204A and 204B are operable to, responsive to word line 250 being asserted, enable reading from and writing to storage node 240 and complementary storage node 242 via bit line 244 and complementary bit line 246.

Because word line 250 is connected to gate terminals 210A and 210B, the high voltage of word line 250 may cause gate terminals 210A and 210B to each emit a high voltage levels. To read the values stored in storage node 240 and complementary storage node 242 from bistable latch 232, word line 250 is asserted, and gate terminals 210A and 210B correspondingly have a high voltage. Because storage node 240 and complementary storage node 242 are connected to drain terminal 212A of electro-mechanical transistor 204A and drain terminal 212B of electro-mechanical transistor 204B, respectively, the values stored in storage node 240 and complementary storage node 242 may cause a potential difference between drain terminal 212A and gate terminal 210A of electro-mechanical transistor 204A or between drain terminal 212B and gate terminal 210B of electro-mechanical transistor 204B.

In the example where bistable latch 232 stores a bit value of 1 (i.e., the value of the bit stored in storage node 240 is 1 and the value of the bit stored in complementary storage node 242 is 0), complementary storage node 242 storing a bit value of 0 may cause a potential difference between drain terminal 212B and gate terminal 210B of electro-mechanical transistor 204B because the bit value of 0 stored in complementary storage node 242 causes drain terminal 212B connected to complementary storage node 242 to be in a low voltage state. The potential difference may cause the cantilever beam (not shown) in electro-mechanical transistor 204B to pull down to cause an electrical short between drain terminal 212B and source terminal 208B, which allows complementary storage node 242 to be accessible to complementary bit line 246.

In the example where bistable latch 232 stores a bit value of 0 (i.e., the value of the bit stored in storage node 240 is 0 and the value of the bit stored in complementary storage node 242 is 1), storage node 240 storing a bit value of 0 may cause a potential difference between drain terminal 212A and gate terminal 210A of electro-mechanical transistor 204A because the bit value of 0 stored in storage node 240 causes drain terminal 212A connected to storage node 240 to be in a low voltage state. The potential difference may cause the cantilever beam (not shown) in electro-mechanical transistor 204A to pull down to cause an electrical short between drain terminal 212A and source terminal 208A, which allows storage node 240 to be accessible to bit line 244.

When the voltage of word line 250 is asserted (i.e., switched to a system high voltage), electro-mechanical transistors 204A and 204B are turned on, and SRAM cell 200 may also perform write operations to bistable latch 232. To write a value of 1 (i.e., write 1 to storage node 240 and 0 to Q'242) into bistable latch 232, assuming that storage node 240 is initialized to 0 and complementary storage node 242 is initialized to 1, bit line 244 is asserted to 1 (e.g., driven to a high voltage, such as the supply voltage) and complementary bit line 246 is de-asserted to 0 (e.g., driven to a low voltage, such as ground). Bit line 244 and word line 250 both being asserted to 1 turns off electro-mechanical transistor 204A due to there being no potential difference between source terminal 208A and gate terminal 210A.

Complementary bit line 246 being de-asserted to 0 while word line 250 is being asserted to 1 turns on electro-mechanical transistor 204B due to a potential difference between source terminal 208B and gate terminal 210B. The potential difference causes the cantilever beam (not shown) in electro-mechanical transistor 204B to pull down to cause an electrical short between drain terminal 212B and source terminal 208B, which causes complementary storage node 242 to be set to store a bit value of 0. Drain terminals 212E and 212F of inverter 230B are cross-connected to gate terminals 210C and 210D of inverter 230A. The value of 0 at gate terminal 210D causes a potential difference in electro-mechanical transistor 204D between source terminal 208D and gate terminal 210D. The potential difference causes the cantilever beam (not shown) in electro-mechanical transistor 204D to pull down to cause an electrical short between drain terminal 212D and source terminal 208D. Because source terminal 208D is connected to VDD 234, drain terminal 212D takes on the high voltage. As a result, storage node 240 is set to store a bit value of 1.

To write a value of 0 (i.e., write 0 to storage node 240 and write 1 to complementary storage node 242) into bistable latch 232, assuming that storage node 240 is initialized to 1 and complementary storage node 242 is initialized to 0, bit line 244 is de-asserted to 0 (e.g., driven to a low voltage, such as ground) and complementary bit line 246 is asserted to 1 (e.g., driven to a high voltage, such as supply voltage). Complementary bit line 246 and word line 250 both being asserted to 1 turns off electro-mechanical transistor 204B due to there being no potential difference between source terminal 208B and gate terminal 210B.

Bit line 244 being de-asserted to 0 while word line 250 is being asserted to 1 turns on electro-mechanical transistor 204A due to a potential difference between source terminal 208A and gate terminal 210A. The potential difference causes the cantilever beam (not shown) in electro-mechanical transistor 204A to pull down to cause an electrical short between drain terminal 212A and source terminal 208A, which causes storage node 240 to be set to store a bit value of 0. Drain terminals 212C and 212D of inverter 230A are cross-connected to gate terminals 210E and 210F of inverter 230B. The value of 0 at gate terminal 210F causes a potential difference in electro-mechanical transistor 204F between source terminal 208F and gate terminal 210F. The potential difference causes the cantilever beam (not shown) in electro-mechanical transistor 204F to pull down to cause an electrical short between drain terminal 212F and source terminal 208F. Because source terminal 208F is connected to VDD 234, drain terminal 212F takes on the high voltage. As a result, complementary storage node 242 is set to store a bit value of 1.

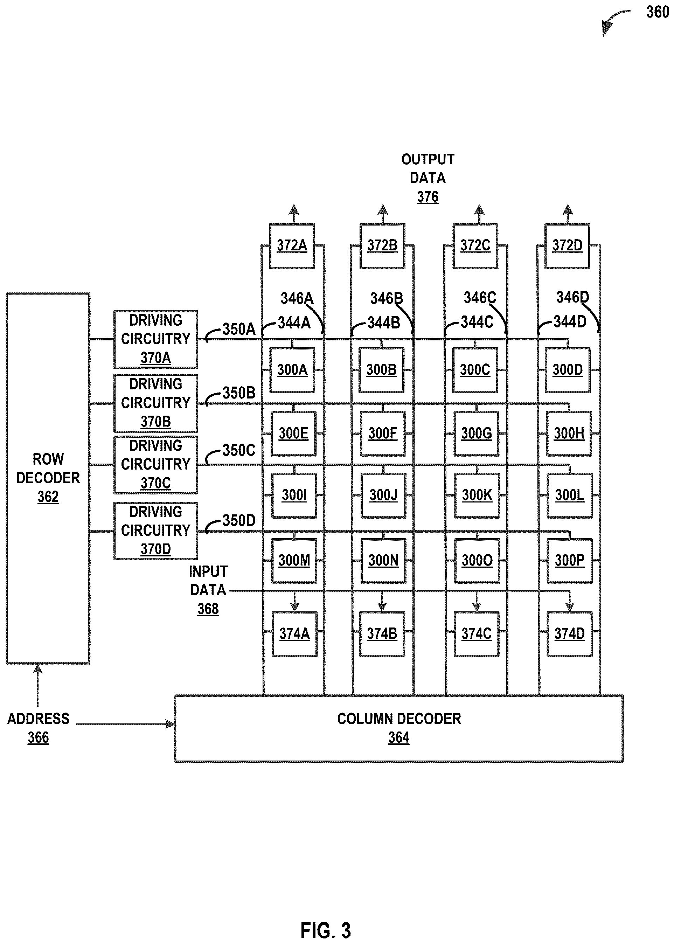

FIG. 3 is a schematic diagram illustrating an example SRAM device having SRAM cells that uses electro-mechanical transistors, in accordance with aspects of this disclosure. SRAM device 360 may be a memory device used as a data storage device in an integrated circuit. As shown in FIG. 3, SRAM device 360 includes SRAM cells 300A-300P ("SRAM cells 300"), each of which is an example of SRAM cell 200 of FIG. 2 that includes electro-mechanical transistors. SRAM device 360 also includes row decoder 362, column decoder 364, driving circuitry 370A-370D ("driving circuitries 370"), sense amplifiers 372A-372D ("sense amplifiers 372"), and write driving circuitry 374A-374D ("write driving circuities 374"). SRAM device 360 may also include additional components and circuitry not shown in FIG. 3. While FIG. 3 illustrates a 4x4 array of SRAM cells 300, the techniques of this disclosure are equally applicable to any other number and/or configuration of SRAM cells in SRAM device 360.

Row decoder 362 is implemented via circuitry and connects to driving circuitries 370. Each driving circuitry of driving circuitries 370 connects to a corresponding word line of word lines 350A-350H ("word lines 350"), each of which is an example of word line 250 of FIG. 2, and each driving circuitry is operable to drive a voltage to a corresponding word line. Row decoder 362 may receive address signal 366, such as from processing circuitry of a computing device, that indicates a memory address (e.g., a physical memory address). Row decoder 362 may determine, based on the physical memory address, using any suitable technique, to select a word line to activate out of word lines 350. Row decoder 362 may therefore use a driving circuitry connected to the selected word line out of driving circuitries 370 to drive the selected word line to a system high voltage, such as a supply voltage, to assert the selected word line.

Column decoder 364 is implemented via circuitry and connects to SRAM cells via bit lines 344A-344H ("bit lines 344"), each of which is an example of bit line 244 of FIG. 2, and via complementary bit lines 346A-346H ("complementary bit lines 346"), each of which is an example of complementary bit line 246 of FIG. 2. Column decoder 364 may also receive address signal 366 that indicates a memory address and may, select, based on the memory address, a bit line out of bit lines 344 and a complementary bit line out of complementary bit lines 346 to read from and write to a SRAM cell.

To select a SRAM cell for writing a bit value to the SRAM cell, column decoder 364 may select the corresponding write driving circuitry, out of write driving circuitries 374, connected to the bit line and complementary bit line for the SRAM cell to drive the appropriate voltages to the bit line and complementary bit line for the SRAM cell to write a bit value to the SRAM cell. To select a SRAM cell for reading the bit value stored in the SRAM cell, column decoder may connect the corresponding sense amplifier, out of sense amplifiers 372, to the bit line and complementary bit line for the SRAM cell to sense the bit value stored in the SRAM cell.

For example, if the memory address indicated by address signal 366 addresses SRAM cells that include SRAM cell 300C, row decoder 362 may determine, based on the memory address, to assert word line 350A, such as by using driving circuitry 370A to drive word line 350A to a system high voltage. Column decoder 364 may, based on the memory address, select bit line 344C and complementary bit line 346C to read from and write to SRAM cell 300C.

SRAM device 360 may use write driving circuitries 374 to write data to SRAM cells 300. Write driving circuitries 374 may receive input data signal 368 that indicates input data to be written to SRAM cells 300 and may write the input data to the SRAM cells addressed by the memory address indicated by address signal 366. Each write driving circuitry is connected to a bit line and a complementary bit line. For example, write driving circuitry 374A is connected to bit line 344A and complementary bit line 346A, write driving circuitry 374B is connected to bit line 344B and complementary bit line 346B, write driving circuitry 374C is connected to bit line 344C and complementary bit line 346C, and write driving circuitry 374D is connected to bit line 344D and complementary bit line 346D.

In the example of writing a bit value of 1 to SRAM cell 300L, row decoder 362 may use drive circuitry 370C to assert word line 350C connected to SRAM cell 300L. Column decoder 364 may also select bit line 344D and complementary bit line 346D to be used to write to SRAM cell 300L. SRAM device 360 may use write driving circuitry 374D write a bit value of 1 to the storage node of SRAM cell 300L and to write a bit value of 0 to the complementary storage node of SRAM cell 300L. To write a bit value of 1 to the storage node of SRAM cell 300L and to write a bit value of 0 to the complementary storage node of SRAM cell 300L, driving circuitry 374D may drive bit line 344D to a high voltage (e.g., a supply voltage) to assert bit line 344D to 1 and may drive complementary bit line 346D to a low voltage (e.g., ground) to de-assert complementary bit line 346D to 0.

In the example of writing a bit value of 0 to SRAM cell 300L, row decoder 362 may use drive circuitry 370C to assert word line 350C connected to SRAM cell 300L. Column decoder 364 may also select bit line 344D and complementary bit line 346D to be used to write to SRAM cell 300L. SRAM device 360 may use write driving circuitry 374D write a bit value of 0 to the storage node of SRAM cell 300L and to write a bit value of 1 to the complementary storage node of SRAM cell 300L. To write a bit value of 0 to the storage node of SRAM cell 300L and to write a bit value of 1 to the complementary storage node of SRAM cell 300L, driving circuitry 374D may drive bit line 344D to a low voltage (e.g., ground) to de-assert bit line 344D to 0 and may drive complementary bit line 346D to a high voltage (e.g., a supply voltage) to assert complementary bit line 346D to 1.

SRAM device 360 may use sense amplifiers 372 to read data from SRAM cells 300. Each of sense amplifiers 372 is associated with a corresponding pair of bit line and complementary bit line, and each of sense amplifiers 372 may be a differential amplifier that amplifies voltage differences between the corresponding pair of bit line and complementary bit line. In the example of SRAM device 360, sense amplifier 372A is associated with bit line 344A and complementary bit line 346A, sense amplifier 372B is associated with bit line 344B and complementary bit line 346B, sense amplifier 372C is associated with bit line 344C and complementary bit line 346C, and sense amplifier 372D is associated with bit line 344D and complementary bit line 346D.

To read the bit value stored in a SRAM cell, SRAM device 360 may pre-charge bit lines 344 and complementary bit lines 346 to a high voltage level, such as the supply voltage. Row decoder 362 may then use an appropriate drive circuitry to assert the word line connected to the SRAM cell. Column decoder 364 may connect a corresponding sense amplifier to the bit line and the complementary bit line for the SRAM cell. The sense amplifier may detect and amplify the voltage differential between the connected bit line and complementary bit line to a logic high (e.g., supply voltage) or to a logic low (e.g., ground), and SRAM device 360 may send output data signal 376 that indicates the output of the sense amplifier.

For example, to read the value stored in SRAM cell 300N, row decoder 362 may, after SRAM device 360 pre-charges bit lines 344 and complementary bit lines 346 to a high voltage level, use driving circuitry 370D to assert word line 350D connected to SRAM cell 300N. Column decoder 364 may connect sense amplifier 372B to bit line 344B and complementary bit line 346B. Sense amplifier 372B may sense and amplify the voltage differential between bit line 344B and complementary bit line 346B connected to SRAM cell 300N. If sense amplifier 372B senses that the voltage of bit line 344B is greater than the voltage of bit line 346B, sense amplifier 372B may output a logic high (e.g., a 1), and SRAM device 360 may indicate, in output data signal 376, that SRAM cell 300N is storing a 1. If sense amplifier 372B senses that the voltage of bit line 344B is less than the voltage of bit line 346B, sense amplifier 372B may output a logic low (e.g., a 0), and SRAM device 360 may indicate, in output data signal 376, that SRAM cell 300N is storing a 0. SRAM device 360 may therefore send output data signal 376 to, e.g., a processing circuitry of a computing device.

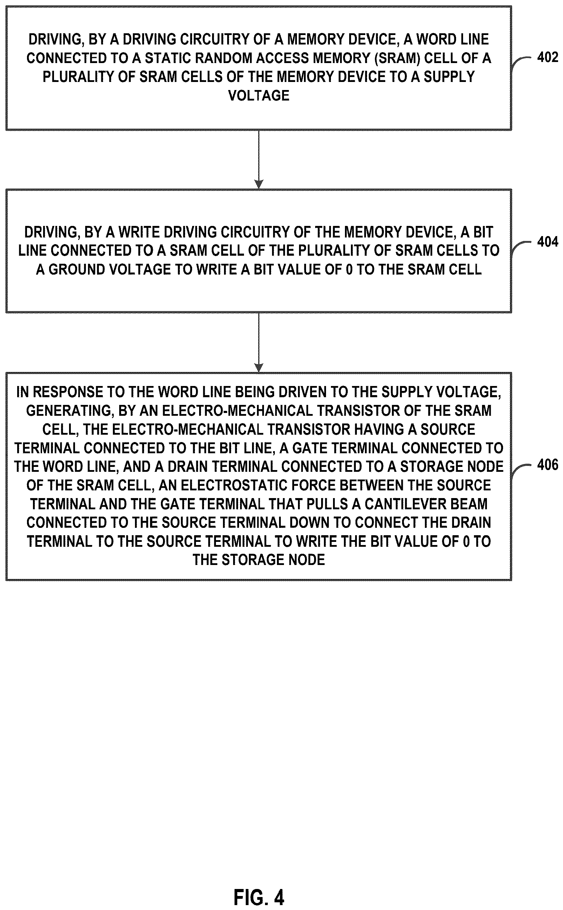

FIG. 4 is a flow chart illustrating example operations of a memory device. FIG. 4 is described with respect to FIGS. 2 and 3.

As shown in FIG. 4, a driving circuitry 370A of driving circuitries 370 of a memory device 360 may drive a word line 350A of word lines 350 connected to a Static Random Access Memory (SRAM) cell 300B of a plurality of SRAM cells 300 of the memory device 360 to a supply voltage (402). A write driving circuitry of write driving circuitries 374 of memory device 360 may drive a bit line 344B connected to a SRAM cell 300B of the plurality of SRAM cells 300 to a ground voltage to write a bit value of 0 to the SRAM cell 300B (404). An electro-mechanical transistor 204A of the SRAM cell 300B may, in response to the word line 350A being driven to the supply voltage, generating, by an electro-mechanical transistor of the SRAM cell, the electro-mechanical transistor 204A having a source terminal 208A connected to the bit line 344B, a gate terminal 210A connected to the word line 350A, and a drain terminal 212A connected to a storage node 240 of the SRAM cell 300B, generate an electrostatic force between the source terminal 208A and the gate terminal 210A that pulls a cantilever beam connected to the source terminal 208A down to connect the drain terminal 212A to the source terminal 208A to write the bit value of 0 to the storage node 240 (406).

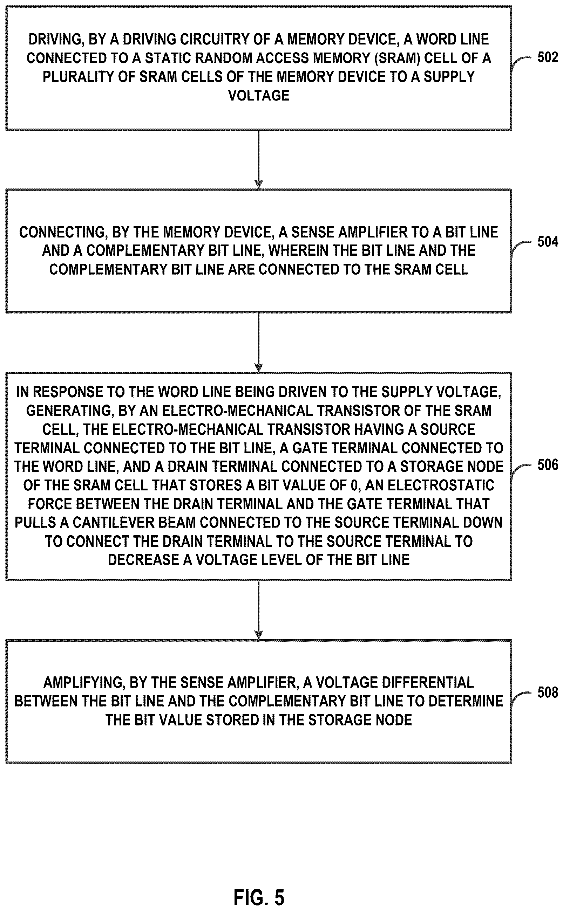

FIG. 5 is a flow chart illustrating example operations of a memory device. FIG. 4 is described with respect to FIGS. 2 and 3.

As shown in FIG. 5, a driving circuitry 370A of driving circuitries 370 of a memory device 360 may drive a word line 350A of word lines 350 connected to a Static Random Access Memory (SRAM) cell 300B of a plurality of SRAM cells 300 of the memory device 360 to a supply voltage (502). Memory device 360 may connect a sense amplifier 372B of sense amplifiers 372 to a bit line 344B and a complementary bit line 346B, wherein the bit line 344B and the complementary bit line 346B are connected to the SRAM cell 300B (504).

An electro-mechanical transistor 204A of the SRAM cell 300B may, in response to the word line 350A being driven to the supply voltage, generating, by an electro-mechanical transistor of the SRAM cell, the electro-mechanical transistor 204A having a source terminal 208A connected to the bit line 344B, a gate terminal 210A connected to the word line 350A, and a drain terminal 212A connected to a storage node 240 of the SRAM cell 300B that stores a bit value of 0, generate an electrostatic force between the drain terminal 212A and the gate terminal 210A that pulls a cantilever beam connected to the source terminal 208A down to connect the drain terminal 212A to the source terminal 208A to decrease a voltage level of the bit line 344B (506). The sense amplifier 372B may amplify a voltage differential between the bit line 344B and the complementary bit line 346B to determine the bit value stored in the storage node 240 (508).

The techniques of this disclosure may also be described in the following clauses.

Clause 1. A Static Random Access Memory (SRAM) cell comprising: a set of electro-mechanical transistors, wherein each electro-mechanical transistor of the set of electro-mechanical transistors comprises: a source terminal; a gate terminal; a drain terminal; and a cantilever beam connected to the source terminal, wherein the cantilever beam is operable to deflect to connect the drain terminal to the source terminal responsive to an electrostatic force generated by a potential difference between the source terminal and the drain terminal; and a bistable latch connected to a supply voltage and to a ground, the bistable latch having a first storage node and a second storage node, the second storage node being complementary to the first storage node, wherein the drain terminal of a first electro-mechanical transistor of the set of electro-mechanical transistors is connected to the first storage node, and wherein the drain terminal of a second electro-mechanical transistor of the set of electro-mechanical transistors is connected to the second storage node; wherein the gate terminal of the first electro-mechanical transistor and the gate terminal of the second electro-mechanical transistor are connected to a word line; wherein the source terminal of the first electro-mechanical transistor is connected to a bit line; wherein the source terminal of the second electro-mechanical transistor is connected to a complementary bit line; and wherein the first electro-mechanical transistor and the second electro-mechanical transistor are operable to enable reading from and writing to the first storage node and the second storage node via the bit line and the complementary bit line responsive to the word line being asserted.

Clause 2. The SRAM cell of clause 1, wherein the bistable latch includes a pair of cross-coupled inverters, the pair of cross-coupled inverters including a plurality of electro-mechanical transistors of the set of electro-mechanical transistors.

Clause 3. The SRAM cell of clause 2, wherein: a first inverter of the pair of cross-coupled inverters includes a third electro-mechanical transistor of the set of electro-mechanical transistors and a fourth electro-mechanical transistor; a second inverter of the pair of cross-coupled inverters includes a fifth electro-mechanical transistor of the set of electro-mechanical transistors and a sixth electro-mechanical transistor; the source terminal of the third electro-mechanical transistor and the source terminal of the fifth electro-mechanical transistor are connected to the ground; the source terminal of the fourth electro-mechanical transistor and the source terminal of the sixth electro-mechanical transistor are connected to the supply voltage; the gate terminal of the third electro-mechanical transistor is connected to the gate terminal of the fourth electro-mechanical transistor; the gate terminal of the fifth electro-mechanical transistor is connected to the gate terminal of the sixth electro-mechanical transistor; the drain terminal of the third electro-mechanical transistor and the drain terminal of the fourth electro-mechanical transistor are connected to the first storage node; the drain terminal of the fifth electro-mechanical transistor and the drain terminal of the sixth electro-mechanical transistor are connected to the second storage node; the gate terminal of the third electro-mechanical transistor and the gate terminal of the fourth electro-mechanical transistor are cross-connected to the drain terminal of the fifth electro-mechanical transistor and the drain terminal of the sixth electro-mechanical transistor; and the gate terminal of the fifth electro-mechanical transistor and the gate terminal of the sixth electro-mechanical transistor are cross-connected to the drain terminal of the third electro-mechanical transistor and the drain terminal of the fourth electro-mechanical transistor.

Clause 4. The SRAM cell of any of clauses 1-3, wherein each of the set of electro-mechanical transistors is a micro-electromechanical systems (MEMS) transistor.

Clause 5. The SRAM cell of any of clauses 1-4, wherein to write a bit value of 0 to the first storage node, the bit line being driven to a low voltage causes a potential difference between the source terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the drain terminal of the first electro-mechanical transistor to write the bit value of 0 to the first storage node.

Clause 6. The SRAM cell of any of clauses 1-5, wherein to write a bit value of 0 to the second storage node, the complementary bit line being driven to a low voltage causes a potential difference between the source terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the drain terminal of the second electro-mechanical transistor to write the bit value of 0 to the second storage node.

Clause 7. The SRAM cell of any of clauses 1-6, wherein to read a bit value of 0 from the first storage node, the bit value of 0 in the first storage node causes a potential difference between the drain terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the bit line to read the bit value of 0 from the first storage node.

Clause 8. The SRAM cell of any of clauses 1-7, wherein to read a bit value of 0 from the second storage node, the bit value of 0 in the second storage node causes a potential difference between the drain terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the complementary bit line to read the bit value of 0 from the second storage node.

Clause 9. The SRAM cell of any of clauses 1-8, wherein the SRAM cell is a 6T SRAM cell.

Clause 10. The SRAM cell of any of clauses 1-9, wherein the SRAM cell is included in a plurality of SRAM cells of a SRAM device.

Clause 11. A Static Random Access Memory (SRAM) device comprising: a plurality of word lines; a plurality of bit lines; a plurality of complementary bit lines; a plurality of driving circuitries operable to drive the plurality of word lines; a plurality of SRAM cells, wherein each SRAM cell of the plurality of SRAM cells includes: a set of electro-mechanical transistors, wherein each electro-mechanical transistor of the set of electro-mechanical transistors comprises: a source terminal; a gate terminal; a drain terminal; and a cantilever beam connected to the source terminal, wherein the cantilever beam is operable to deflect to connect the drain terminal to the source terminal responsive to an electrostatic force generated by a potential difference between the source terminal and the drain terminal; and a bistable latch connected to a supply voltage and to a ground, the bistable latch having a first storage node and a second storage node, the second storage node being complementary to the first storage node, wherein the drain terminal of a first electro-mechanical transistor of the set of electro-mechanical transistors is connected to the first storage node, and wherein the drain terminal of a second electro-mechanical transistor of the set of electro-mechanical transistors is connected to the second storage node; wherein the gate terminal of the first electro-mechanical transistor and the gate terminal of the second electro-mechanical transistor are connected to a word line of the plurality of word lines; wherein the source terminal of the first electro-mechanical transistor is connected to a bit line of the plurality of bit lines; wherein the source terminal of the second electro-mechanical transistor is connected to a complementary bit line of the plurality of complementary bit lines; and wherein the first electro-mechanical transistor and the second electro-mechanical transistor are operable to enable reading from and writing to the first storage node and the second storage node via the bit line and the complementary bit line responsive to the word line being asserted by a corresponding driving circuitry of the plurality of driving circuitries.

Clause 12. The SRAM device of clause 11, wherein the bistable latch includes a pair of cross-coupled inverters, the pair of cross-coupled inverters including a plurality of electro-mechanical transistors of the set of electro-mechanical transistors.

Clause 13. The SRAM device of clause 12, wherein: a first inverter of the pair of cross-coupled inverters includes a third electro-mechanical transistor of the set of electro-mechanical transistors and a fourth electro-mechanical transistor; a second inverter of the pair of cross-coupled inverters includes a fifth electro-mechanical transistor of the set of electro-mechanical transistors and a sixth electro-mechanical transistor; the source terminal of the third electro-mechanical transistor and the source terminal of the fifth electro-mechanical transistor are connected to the ground; the source terminal of the fourth electro-mechanical transistor and the source terminal of the sixth electro-mechanical transistor are connected to the supply voltage; the gate terminal of the third electro-mechanical transistor is connected to the gate terminal of the fourth electro-mechanical transistor; the gate terminal of the fifth electro-mechanical transistor is connected to the gate terminal of the sixth electro-mechanical transistor; the drain terminal of the third electro-mechanical transistor and the drain terminal of the fourth electro-mechanical transistor are connected to the first storage node; the drain terminal of the fifth electro-mechanical transistor and the drain terminal of the sixth electro-mechanical transistor are connected to the second storage node; the gate terminal of the third electro-mechanical transistor and the gate terminal of the fourth electro-mechanical transistor are cross-connected to the drain terminal of the fifth electro-mechanical transistor and the drain terminal of the sixth electro-mechanical transistor; and the gate terminal of the fifth electro-mechanical transistor and the gate terminal of the sixth electro-mechanical transistor are cross-connected to the drain terminal of the third electro-mechanical transistor and the drain terminal of the fourth electro-mechanical transistor.

Clause 14. The SRAM device of any of clauses 11-13, wherein each of the set of electro-mechanical transistors is a micro-electromechanical systems (MEMS) transistor.

Clause 15. The SRAM device of any of clauses 11-14, wherein to write a bit value of 0 to the first storage node, the bit line being driven to a low voltage causes a potential difference between the source terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the drain terminal of the first electro-mechanical transistor to write the bit value of 0 to the first storage node.

Clause 16. The SRAM device of any of clauses 11-15, wherein to write a bit value of 0 to the second storage node, the complementary bit line being driven to a low voltage causes a potential difference between the source terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the drain terminal of the second electro-mechanical transistor to write the bit value of 0 to the second storage node.

Clause 17. The SRAM device of any of clauses 11-16, wherein to read a bit value of 0 from the first storage node, the bit value of 0 in the first storage node causes a potential difference between the drain terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the bit line to read the bit value of 0 from the first storage node.

Clause 18. The SRAM device of any of clauses 11-17, wherein to read a bit value of 0 from the second storage node, the bit value of 0 in the second storage node causes a potential difference between the drain terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the complementary bit line to read the bit value of 0 from the second storage node.

Clause 19. The SRAM device of any of clauses 11-18, wherein each SRAM cell of the plurality of SRAM cells is a 6T SRAM cell.

Clause 20. A method of operating a memory device comprising: driving, by a driving circuitry of a memory device, a word line connected to a Static Random Access Memory (SRAM) cell of a plurality of SRAM cells of the memory device to a supply voltage; driving, by a write driving circuitry of the memory device, a bit line connected to a SRAM cell of the plurality of SRAM cells to a ground voltage to write a bit value of 0 to the SRAM cell; and in response to the word line being driven to the supply voltage, generating, by an electro-mechanical transistor of the SRAM cell, the electro-mechanical transistor having a source terminal connected to the bit line, a gate terminal connected to the word line, and a drain terminal connected to a storage node of the SRAM cell, an electrostatic force between the source terminal and the gate terminal that pulls a cantilever beam connected to the source terminal down to connect the drain terminal to the source terminal to write the bit value of 0 to the storage node.

Various examples of the disclosure have been described. These and other examples are within the scope of the following claims.

## Claims

1. A Static Random Access Memory (SRAM) cell comprising:
a set of electro-mechanical transistors, wherein each electro-mechanical transistor of the set of electro-mechanical transistors comprises:
a source terminal;
a gate terminal;
a drain terminal; and
a cantilever beam connected to the source terminal, wherein the cantilever beam is operable to deflect to connect the drain terminal to the source terminal responsive to an electrostatic force generated by a potential difference between the source terminal and the drain terminal; and
a bistable latch connected to a supply voltage and to a ground, the bistable latch having a first storage node and a second storage node, the second storage node being complementary to the first storage node, wherein the drain terminal of a first electro-mechanical transistor of the set of electro-mechanical transistors is connected to the first storage node, and wherein the drain terminal of a second electro-mechanical transistor of the set of electro-mechanical transistors is connected to the second storage node;
wherein the gate terminal of the first electro-mechanical transistor and the gate terminal of the second electro-mechanical transistor are connected to a word line;
wherein the source terminal of the first electro-mechanical transistor is connected to a bit line;
wherein the source terminal of the second electro-mechanical transistor is connected to a complementary bit line; and
wherein the first electro-mechanical transistor and the second electro-mechanical transistor are operable to enable reading from and writing to the first storage node and the second storage node via the bit line and the complementary bit line responsive to the word line being asserted.

2. The SRAM cell of claim **1,** wherein the bistable latch includes a pair of cross-coupled inverters, the pair of cross-coupled inverters including a plurality of electro-mechanical transistors of the set of electro-mechanical transistors.

3. The SRAM cell of claim 2, wherein:
a first inverter of the pair of cross-coupled inverters includes a third electro-mechanical transistor of the set of electro-mechanical transistors and a fourth electro-mechanical transistor;
a second inverter of the pair of cross-coupled inverters includes a fifth electro-mechanical transistor of the set of electro-mechanical transistors and a sixth electro-mechanical transistor;
the source terminal of the third electro-mechanical transistor and the source terminal of the fifth electro-mechanical transistor are connected to the ground;
the source terminal of the fourth electro-mechanical transistor and the source terminal of the sixth electro-mechanical transistor are connected to the supply voltage;
the gate terminal of the third electro-mechanical transistor is connected to the gate terminal of the fourth electro-mechanical transistor;
the gate terminal of the fifth electro-mechanical transistor is connected to the gate terminal of the sixth electro-mechanical transistor;
the drain terminal of the third electro-mechanical transistor and the drain terminal of the fourth electro-mechanical transistor are connected to the first storage node;
the drain terminal of the fifth electro-mechanical transistor and the drain terminal of the sixth electro-mechanical transistor are connected to the second storage node;
the gate terminal of the third electro-mechanical transistor and the gate terminal of the fourth electro-mechanical transistor are cross-connected to the drain terminal of the fifth electro-mechanical transistor and the drain terminal of the sixth electro-mechanical transistor; and
the gate terminal of the fifth electro-mechanical transistor and the gate terminal of the sixth electro-mechanical transistor are cross-connected to the drain terminal of the third electro-mechanical transistor and the drain terminal of the fourth electro-mechanical transistor.

4. The SRAM cell of any of claims 1-3, wherein to write a bit value of 0 to the first storage node, the bit line being driven to a low voltage causes a potential difference between the source terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the drain terminal of the first electro-mechanical transistor to write the bit value of 0 to the first storage node.

5. The SRAM cell of any of claims 1-4, wherein to write a bit value of 0 to the second storage node, the complementary bit line being driven to a low voltage causes a potential difference between the source terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the drain terminal of the second electro-mechanical transistor to write the bit value of 0 to the second storage node.

6. The SRAM of any of claims 1-5, wherein to read a bit value of 0 from the first storage node, the bit value of 0 in the first storage node causes a potential difference between the drain terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the bit line to read the bit value of 0 from the first storage node.

7. The SRAM cell of any of claims 1-6, wherein to read a bit value of 0 from the second storage node, the bit value of 0 in the second storage node causes a potential difference between the drain terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the complementary bit line to read the bit value of 0 from the second storage node.

8. A Static Random Access Memory (SRAM) device comprising:
a plurality of word lines;
a plurality of bit lines;
a plurality of complementary bit lines;
a plurality of driving circuitries operable to drive the plurality of word lines;
a plurality of SRAM cells, wherein each SRAM cell of the plurality of SRAM cells includes:
a set of electro-mechanical transistors, wherein each electro-mechanical transistor of the set of electro-mechanical transistors comprises:
a source terminal;
a gate terminal;
a drain terminal; and
a cantilever beam connected to the source terminal, wherein the cantilever beam is operable to deflect to connect the drain terminal to the source terminal responsive to an electrostatic force generated by a potential difference between the source terminal and the drain terminal; and
a bistable latch connected to a supply voltage and to a ground, the bistable latch having a first storage node and a second storage node, the second storage node being complementary to the first storage node, wherein the drain terminal of a first electro-mechanical transistor of the set of electro-mechanical transistors is connected to the first storage node, and wherein the drain terminal of a second electro-mechanical transistor of the set of electro-mechanical transistors is connected to the second storage node;
wherein the gate terminal of the first electro-mechanical transistor and the gate terminal of the second electro-mechanical transistor are connected to a word line of the plurality of word lines;
wherein the source terminal of the first electro-mechanical transistor is connected to a bit line of the plurality of bit lines;
wherein the source terminal of the second electro-mechanical transistor is connected to a complementary bit line of the plurality of complementary bit lines; and
wherein the first electro-mechanical transistor and the second electro-mechanical transistor are operable to enable reading from and writing to the first storage node and the second storage node via the bit line and the complementary bit line responsive to the word line being asserted by a corresponding driving circuitry of the plurality of driving circuitries.

9. The SRAM device of claim 8, wherein the bistable latch includes a pair of cross-coupled inverters, the pair of cross-coupled inverters including a plurality of electro-mechanical transistors of the set of electro-mechanical transistors.

10. The SRAM device of claim 9, wherein:
a first inverter of the pair of cross-coupled inverters includes a third electro-mechanical transistor of the set of electro-mechanical transistors and a fourth electro-mechanical transistor;
a second inverter of the pair of cross-coupled inverters includes a fifth electro-mechanical transistor of the set of electro-mechanical transistors and a sixth electro-mechanical transistor;
the source terminal of the third electro-mechanical transistor and the source terminal of the fifth electro-mechanical transistor are connected to the ground;
the source terminal of the fourth electro-mechanical transistor and the source terminal of the sixth electro-mechanical transistor are connected to the supply voltage;
the gate terminal of the third electro-mechanical transistor is connected to the gate terminal of the fourth electro-mechanical transistor;
the gate terminal of the fifth electro-mechanical transistor is connected to the gate terminal of the sixth electro-mechanical transistor;
the drain terminal of the third electro-mechanical transistor and the drain terminal of the fourth electro-mechanical transistor are connected to the first storage node;
the drain terminal of the fifth electro-mechanical transistor and the drain terminal of the sixth electro-mechanical transistor are connected to the second storage node;
the gate terminal of the third electro-mechanical transistor and the gate terminal of the fourth electro-mechanical transistor are cross-connected to the drain terminal of the fifth electro-mechanical transistor and the drain terminal of the sixth electro-mechanical transistor; and
the gate terminal of the fifth electro-mechanical transistor and the gate terminal of the sixth electro-mechanical transistor are cross-connected to the drain terminal of the third electro-mechanical transistor and the drain terminal of the fourth electro-mechanical transistor.

11. The SRAM device of any of claims 8-10, wherein to write a bit value of 0 to the first storage node, the bit line being driven to a low voltage causes a potential difference between the source terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the drain terminal of the first electro-mechanical transistor to write the bit value of 0 to the first storage node.

12. The SRAM device of any of claims 8-11, wherein to write a bit value of 0 to the second storage node, the complementary bit line being driven to a low voltage causes a potential difference between the source terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the drain terminal of the second electro-mechanical transistor to write the bit value of 0 to the second storage node.

13. The SRAM device of any of claims 8-12, wherein to read a bit value of 0 from the first storage node, the bit value of 0 in the first storage node causes a potential difference between the drain terminal of the first electro-mechanical transistor and the gate terminal of the first electro-mechanical transistor that generates an electrostatic force, the electrostatic force pulling down the cantilever beam of the first electro-mechanical transistor to connect the drain terminal of the first electro-mechanical transistor to the source terminal of the first electro-mechanical transistor and to enable the bit line to read the bit value of 0 from the first storage node.

14. The SRAM device of any of claims 8-13, wherein to read a bit value of 0 from the second storage node, the bit value of 0 in the second storage node causes a potential difference between the drain terminal of the second electro-mechanical transistor and the gate terminal of the second electro-mechanical transistor that generates an electrostatic force, the electrostatic force pulling down the cantilever beam of the second electro-mechanical transistor to connect the drain terminal of the second electro-mechanical transistor to the source terminal of the second electro-mechanical transistor and to enable the complementary bit line to read the bit value of 0 from the second storage node.

15. A method of operating a memory device comprising:
driving, by a driving circuitry of a memory device, a word line connected to a Static Random Access Memory (SRAM) cell of a plurality of SRAM cells of the memory device to a supply voltage;
driving, by a write driving circuitry of the memory device, a bit line connected to a SRAM cell of the plurality of SRAM cells to a ground voltage to write a bit value of 0 to the SRAM cell; and
in response to the word line being driven to the supply voltage, generating, by an electro-mechanical transistor of the SRAM cell, the electro-mechanical transistor having a source terminal connected to the bit line, a gate terminal connected to the word line, and a drain terminal connected to a storage node of the SRAM cell, an electrostatic force between the source terminal and the gate terminal that pulls a cantilever beam connected to the source terminal down to connect the drain terminal to the source terminal to write the bit value of 0 to the storage node.
